# EUROPEAN PATENT APPLICATION

(11) **EP 2 149 817 A2**
(43) Date of publication of application: **03.02.2010**
(21) Application number: 09156788.3
(22) Date of filing: 31.03.2009
(51) Int. Cl.: G03F 7/00

(54) **Method of producing mold**

(30) Priority: 29.07.2008 JP 2008195035
(71) Applicant: Fujitsu Limited, Kawasaki-shi, Kanagawa 211-8588 (JP)
(72) Inventor: Furui, Toshikazu, Kawasaki-shi Kanagawa 211-8588 (JP)
(74) Representative: Körfer, Thomas

(57) **Abstract**

A method for producing a mold, used for imprint, by dry etching a substrate made of quartz by using a dry etching apparatus, the method includes: a mask forming step for forming an etching mask having a concave and convex pattern on the substrate, and an etching step for forming a protective film on a side wall of the etching mask and for etching the substrate at the same time.

## Description

### FIELD

The embodiment discussed herein is related to a method for producing a mold.

### BACKGROUND

Conventionally, imprint technologies are known. In the imprint technologies, a resin having liquidity is applied to a substrate to be processed and then a mold with a concave and convex pattern is pushed to the resin, thereby transcribing the concave and convex pattern on the resin. In the mold for imprint, it is desirable for an opening dimension of the recess portion to be larger outwardly, from the aspect of facilitating the removale of the mold from the hardened resin.

Japanese Laid-open Patent Publication No. 52-32272 (hereinafter referred to as Patent Document 1) discloses a technique for controlling an inclination of a side wall of a recess in a layer to be processed. Japanese Examined Patent Publication No. 06-26205 (hereinafter referred to as Patent Document 2) discloses a technique for forming an opening having a desirably inclinational angle of a composite insulation layer. The mold for imprint is produced by these techniques, so that the recess portion having an opening whose size gradually gets larger outwardly is formed.

However, in the techniques disclosed in Patent Documents 1 and 2, an etching mask may also be eroded. Therefore, the opening dimension of the recess portion at a surface of the substrate is larger than an original opening dimension of the etching mask. Thus, the dimensional accuracy of the mold is degraded.

### SUMMARY

Accordingly, it is an object in one aspect of the embodiment to provide a method for producing a mold, used for imprint, having good dimensional accuracy.

According to an aspect of the embodiment, a method for producing a mold, used for imprint, by dry etching a substrate made of quartz by using a dry etching apparatus, the method includes: a mask forming step for forming an etching mask having a concave and convex pattern on the substrate, and an etching step for forming a protective film on a side wall of the etching mask and for etching the substrate at the same time. The substrate is etched and the protective film is actively formed on the side wall of the etching mask at the same time, thereby preventing the side wall of the etching mask from being eroded.

The object and advantages of the embodiment will be realized and attained by means of the elements and combinations particularly pointed out in the claims.

It is to be understood that both the foregoing general description and the following detailed description are exemplary and explanatory and are not restrictive of the embodiments, as claimed.

### BRIEF DESCRIPTION OF DRAWINGS

FIG. 1 is a schematic view of a dry etching apparatus for producing a mold used for nanoimprint;
FIGs. 2A to 2F are explanatory views of a method for producing the mold;
FIGs. 3A to 3C are explanatory views of the method of forming the concave and convex pattern on a substrate by the conventional technique;
FIGs. 4A and 4B are explanatory views of a protective film;
FIG. 5 is a graph indicating the relationship between a ratio of O₂ gas and F gas, and the film forming rate of the protective film;
FIGs. 6A to 6D are graphs representing results of component analyses of the protective film;
FIGs. 7A and 7B are enlarged views of the vicinity of the recess portion of the substrate after the etching is accomplished;
FIG. 8 is a graph indicating relationships among quartz-etching rate, side wall film forming rate, and taper angle θ;
FIGs. 9A to 9C are graphs representing the relationship between the taper angle θ and O₂/CF;
FIG. 10 is a graph representing the relationship between the ratio of O₂ gas and the CF gas, and the film forming rate of the protective film;
FIG. 11 is a graph representing the relationships among the quartz-etching rate, the side wall film forming rate, and the rate of O₂/CF;
FIGs. 12A and 12B are explanatory views of the relationship between the electric power of a first high-frequency power source and the taper angel;
FIG. 13 is a flowchart of the method for producing the mold;
FIG 14 is the map in which the electric power of the first high-frequency power source and the components of the fluorocarbon correspond to taper angle and depth of the recess portion; and
FIGs. 15A to 15C are explanatory views in the case where the recess portion with a desirable taper angle is formed in the substrate.

### DESCRIPTION OF EMBODIMENTS

A description will be given of an embodiment with reference to the accompanying drawings.

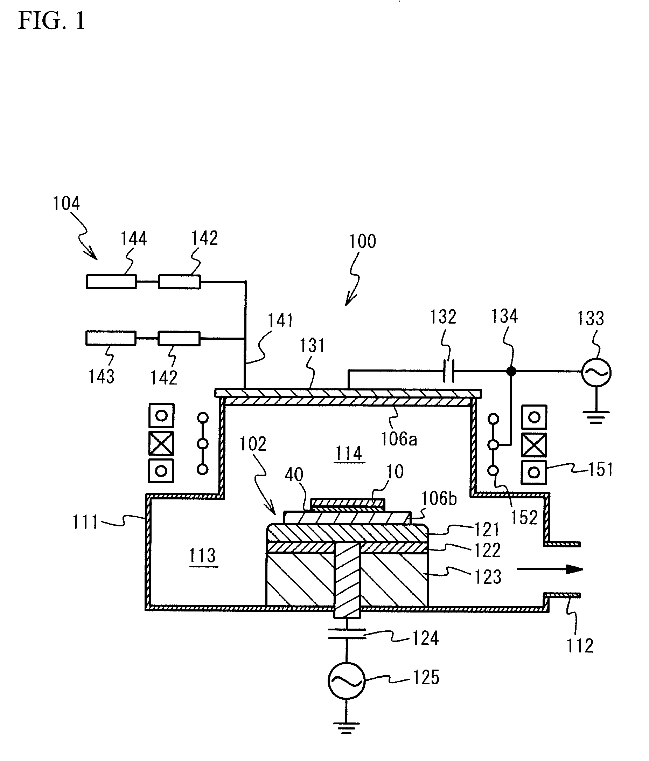

FIG. 1 is a schematic view of a dry etching apparatus 100 for producing a mold used for nanoimprint. The dry etching apparatus 100 is equipped with a vacuum chamber 111, so etching is performed with low-temperature and high-density plasma. The vacuum chamber 111 is provided with a vacuum exhaust portion 112 such as a turbo-molecular pump.

The vacuum chamber 111 is provided at its lower portion with a substrate process chamber 113 and at its upper portion with a plasma generation chamber 114. A substrate mount portion 102 is provided at a central bottom portion within the substrate process chamber 113. The substrate mount portion 102 includes: a substrate electrode 121 on which a substrate 10, to be processed, made of quartz; an insulating body 122, and a supporting stage 123. The substrate electrode 121 and the supporting stage 123 sandwich the insulating body 122. The substrate electrode 121 is electrically connected to a first high-frequency power source 125 via a blocking capacitor 124, and is then brought into a floating electrode in a negative bias potential.

A top substrate 131 is provided at an upper portion of the plasma generation chamber 114 so as to face the substrate mount portion 102. The top board 131 is attached to side walls of the plasma generation chamber 114 so as to seal the plasma generation chamber 114. The top board 131 is electrically connected to a second high-frequency power source 133 via a variable capacitor 132, is brought into a floating state in an electric potential, and serves as an opposed electrode.

The top board 131 is connected to a gas introducing passage 141 of a gas introducing portion 104 for introducing an etching gas into the vacuum chamber 111. The gas introducing passage 141 is branched, and the branched passages are respectively connected to a noble gas source 143 and a fluorocarbon gas source 144 via gas flow rate control portions 142.

The plasma generation chamber 114 includes a dielectric side wall having a cylindrical shape. A magnetic coil 151 is provided around the dielectric side wall. A ring-shaped magnetically neutral line (not illustrated) is generated within the plasma generation chamber 114 by the magnetic coil 151.

A high-frequency antenna coil 152 for generating plasma is arranged between the magnetic coil 151 and the side wall of the plasma generation chamber 114. The high-frequency antenna coil 152 has a parallel antenna structure. The high-frequency antenna coil 152 is electrically connected to a branch point 134 arranged on an electric supply line between the variable capacitor 132 and the second high-frequency power source 133, so that voltage can be applied from the second high-frequency power source 133. When the magnetically neutral line is formed by the magnetic coil 151, alternate discharge electric field is applied along the magnetically neutral line, so the discharge plasma is generated in the magnetically neutral line.

When the etching is performed by the dry etching apparatus 100, the resist mask, which is made of an organic film readily reacting with fluorine atoms in the plasma, may be etched by an etching gas introduced into the vacuum chamber 111. Consequently, a silicon plate 106a, which is made from silicon monocrystal readily reacting with the fluorine atoms, is mounted on a surface, near the substrate electrode 121, of the top board 131. A silicon plate 106b is mounted on the substrate electrode 121. SiF₄ is generated by reacting silicon atoms on the surfaces of these silicon plates 106a and 106b with the fluorine atoms excessively existing in the vacuum chamber 111. Therefore, a part of the fluorine atoms is expended, restricting the resist mask from being etched. Such generated SiF₄ is exhausted out of the dry etching apparatus 100.

Additionally, a substrate 10 is mounted on the silicon plate 106b via a silicon grease 40. The silicon grease 40 is provided for attaching the substrate 10 on the silicon plate 106b and for promoting heat radiation of the substrate 10. The electric power of the first high-frequency power source 125 corresponds to bias power applied to the substrate 10.

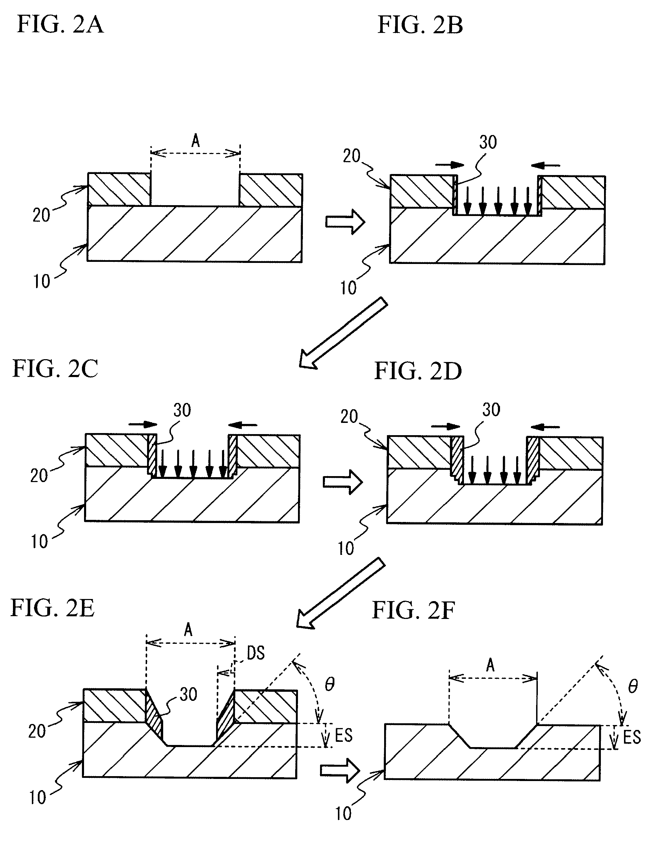

Next, a description will be given of a method for producing the mold for nanoimprint by means of the dry etching apparatus 100. FIGs. 2A to 2F are explanatory views of the method for producing the mold. The substrate 10 is a base material for UV nanoimprint and is made of quartz. As illustrated in FIG. 2A, an etching mask 20 is formed on a front surface of the substrate 10 by use of a publicly-known photolithography technique. As an organic resist material used for the photolithography technique, for example, a KrF resist material or an ArF resist material may be listed up. The pitch distance A of the etching mask 20 corresponds to an opening dimension of a recess portion formed on the substrate 10.

Next, the dry etching is performed by the dry etching apparatus 100 mentioned above. The dry etching is performed as follow: The substrate 10 is mounted on the silicon plate 106b arranged in the vacuum chamber 111, so that the etching gas is introduced from the gas introducing portion 104 into the vacuum chamber 111. The plasma is generated within the plasma generation chamber 114 by applying an RF power from the second high-frequency power source 133. At this time, while the silicon atoms on the surfaces of the silicon plates 106a and 106b and the fluorine atoms are being reacted with each other, the substrate 10 is etched.

As an etching gas, a fluorocarbon gas (hereinafter referred to as CF gas) added with Ar gas and O₂ gas is used. CHF₃ and C₄F₈ are used as a CF gas. In this case, the Ar gas is controlled and introduced by the gas flow rate control portions 142 such that the Ar gas accounts for 80 to 95 percent in the total flow rate of the etching gas. Under the operational pressure of equal to or less than 1.0 Pa in plasma atmosphere, the etching gas of 100 to 300 sccm is introduced into the vacuum chamber 111, so the etching is performed.

When the etching is performed by the above process, the silicon atoms on the surfaces of the silicon plates 106a and 106b react with the fluorine atoms in the plasma, thereby generating SiF₄. SiF₄ is exhausted by the vacuum exhaust portion 112.

Additionally, when the dry etching is performed, a front surface of the substrate 10 exposed from the etching mask 20 is partially etched. At the same time, a protective film 30 is actively formed on a side wall of the etching mask 20, as illustrated in FIGs. 2B, 2C, and 2D. The thickness of the protective film 30 is increased as the etching process proceeds. The protective film 30 includes CF polymer and SiO₂. The protective film 30 includes SiO₂ for the following reason: An O₂ gas introduced into the vacuum chamber 111 reacts with the silicon atoms of the surfaces of the silicon plates 106a and 106b, thereby generating SiO₂. Next, it is conceivable that SiO₂ be attached to the side wall of the etching mask 20. That is, the silicon plates 106a and 106b contribute not only to the reaction with the fluorine atoms in the plasma for the generation of SiF₄ but also to the generation of the protective film 30.

When the dry etching is accomplished, as illustrated in FIG. 2E, the upper surface of the protective film 30 is eroded by the effect of the plasma and obliquely cut. In addition, the side wall of the recess portion formed on the substrate 10 has a taper angle θ. Herein, DS denotes a side wall film forming rate of the protective film 30 formed on the side wall of the etching mask 20, and ES denotes an etching rate of the substrate 10. θ=arctan(ES/DS) is satisfied, where the taper angles is θ, the side wall film formed speed is DS, and the etching rate is ES.

Next, the protective film 30 is removed by a flux such as HFE (Hydorofluoroethers) and ultrasonic cleaning, and the remained etching mask 20 is then removed by wet stripping with a resist stripping agent or sulfuric acid hydrogen peroxide mixture or by dry stripping such as ashing. This allows the concave and convex pattern to be formed on the substrate 10, as illustrated in FIG. 2F.

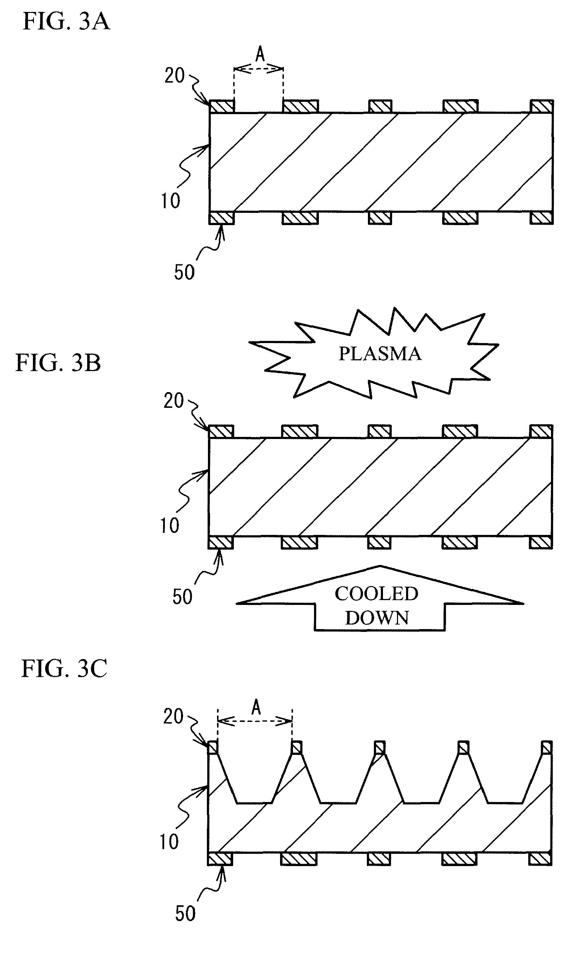

Next, a description will be given of a method of forming the concave and convex pattern on the substrate 10 by a conventional technique. FIGs. 3A to 3C are explanatory views of the method of forming the concave and convex pattern on the substrate 10 by the conventional technique. Additionally, this conventional technique is disclosed in Japanese Laid-open Patent Publication No. 52-032272. As illustrated in FIG. 3A, the etching mask 20 is formed on the upper surface of the substrate 10, and a protective layer 50 is formed on the lower surface of the substrate 10. The substrate 10 and the protective layer 50 have substantially identical patterns therein. Next, the substrate 10 is cooled down from the lower surface thereof, as illustrated in FIG. 3B. The periphery of a portion, of the substrate 10, covered by the protective layer 50 is hardly cooled down, whereas the periphery of another portion, of the substrate 10, exposed from the protective layer 50 is readily cooled down. This causes the temperature distribution within the substrate 10. When the dry etching is performed in this state, the periphery of the portion covered by the protective layer 50 is hardly etched due to the temperature distribution within the substrate 10. For this reason, the recess portion in which the opening dimension gradually gets larger outwardly is formed on the substrate 10.

Herein, the pitch distance A' subsequent to the etching process illustrated in FIG. 3C is larger than the pitch distance A of the original etching mask 20 illustrated in FIG. 3A. The etching mask 20 is also eroded by the effect of the plasma gas, and then the portion, of the substrate 10, covered with the etching mask 20 is also etched. In this way, the conventional technique does not allow the opening dimension of the recess portion to be formed with accuracy.

However, in the producing method according to the present embodiment, the protective film 30 is formed on the side wall of the etching mask 20 at the time when the dry etching is performed, thereby preventing the etching mask 20 from being eroded by the effect of the plasma gas. Therefore, the pitch distance A of the etching mask 20 formed on the substrate 10 is the opening dimension A of the recess portion of the substrate 10. Specifically, at the most outer surface of the substrate 10, the opening dimension A of the recess portion of the substrate 10 corresponds to the pitch distance A. In this manner, the recess portion can be formed on the substrate 10 with accuracy.

Further, for example, when a process for forming the protective film 30 and a process for etching the front surface of the substrate 10 are separately performed, a long time may be needed for the work and its workability may be degraded. However, as described in the producing method according to the present embodiment, the protective film 30 is formed simultaneously with the etching process on the front surface of the substrate 10. Therefore, the recess portion can be formed on the substrate 10 for a short period of time, and its workability can be improved.

Next, a description will be given of the protective film 30 formed when the dry etching is performed. A description will be given of the protective film 30 when the etching is performed under the following conditions.
working pressure: 0.067 Pa
total flow rate of etching gas: 230 sccm
flow rate of Ar gas: 180 to 210 sccm
flow rate of O₂ gas: 0 to 30 sccm
flow rate of C₄F₈: 5 sccm
flow rate of CHF₃: 15 sccm
second high-frequency power source: 2300 w
first high-frequency power source: 0 w
variable capacitor on side of top board: 300 pF

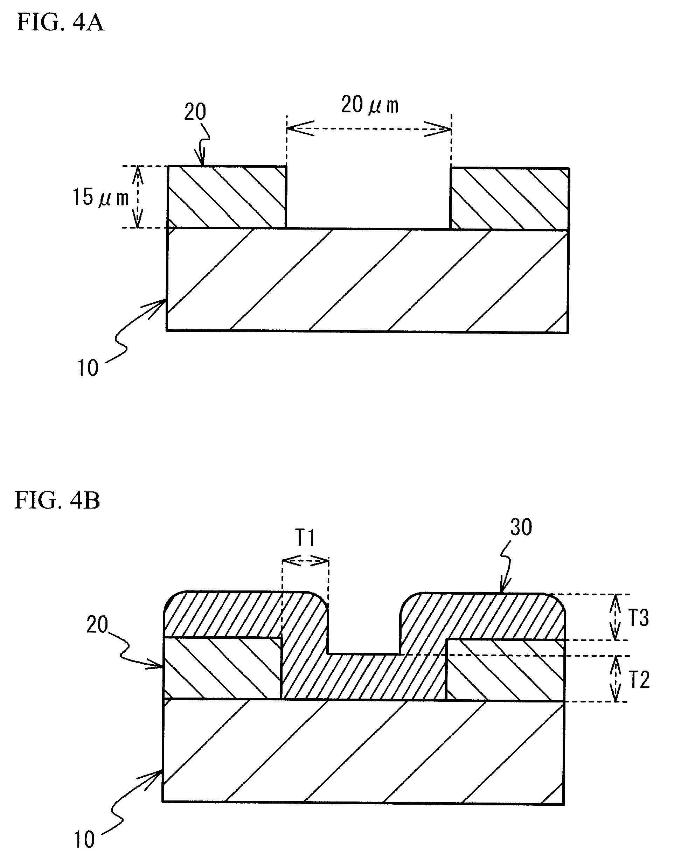

FIGs. 4a and 4b are explanatory views of the protective film 30. As illustrated in FIG. 4A, in the case where the thickness of the etching mask 20 is 15 µm and the pitch distance in the etching mask 20 is 20 µm, the etching is performed under the above conditions. When the etching process is performed, the substrate 10 and the etching mask 20 are covered with the protective film 30, as illustrated in FIG. 4B. This is because the voltage of the first high-frequency power source 125 is set to 0 w. Therefore, ions are not drawn to the substrate 10. Additionally, T1 denotes the thickness of the protective film 30 formed on the side wall of the etching mask 20, as illustrated in FIG. 4B. T2 denotes the thickness of the protective film 30 formed on the upper surface of the substrate 10. T3 denotes the thickness of the protective film 30 formed on the upper surface of the etching mask 20.

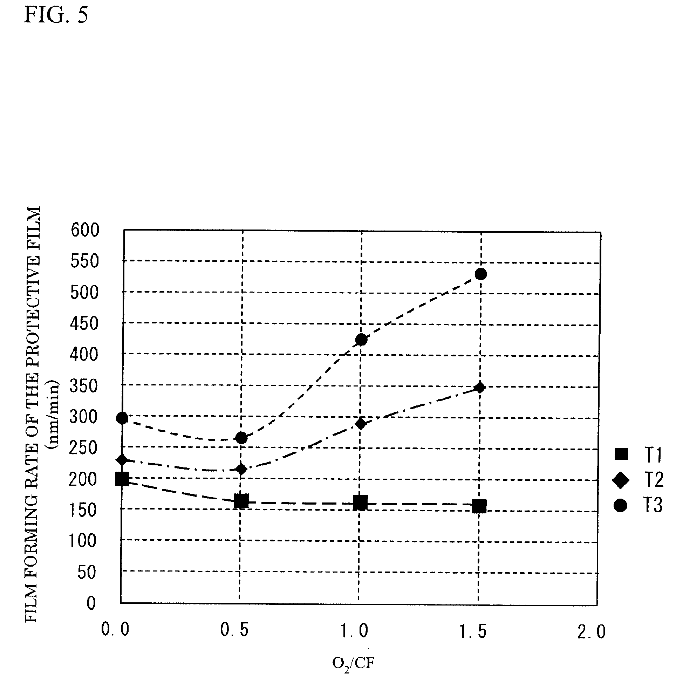

Next, a description will be given of the film forming rate of the protective film 30 when the etching process is performed under the conditions mentioned above. FIG. 5 is a graph indicating the relationship between a ratio of O₂ gas and F gas, and the film forming rate of the protective film 30. The horizontal axis represents the ratio of O₂ gas and the CF gas (hereinafter referred to as O₂/CF), and the vertical axis represents the film forming rate (nm/min) of the protective film 30. O₂/CF is changed by changing the flow rate of O₂ gas. As illustrated in FIG. 5, the film forming rates of the thickness T1 and the thickness T2 are increased as the flow rare of O₂ is increased. On the contrary, the film forming rate of thickness T3 is substantially constant. In this way, the film forming rate of the protective film 30 can be controlled by controlling O₂/CF.

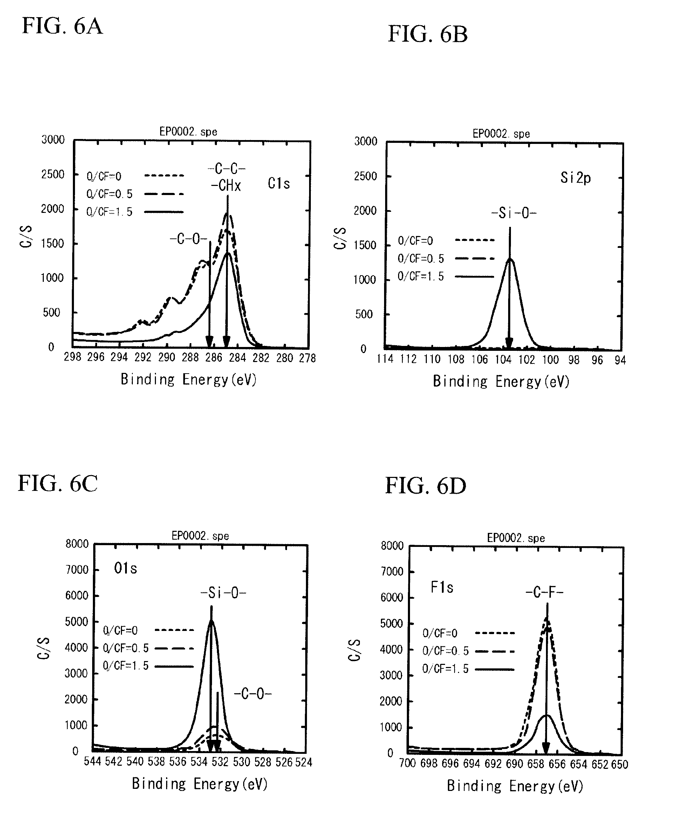

Next, a description will be given of components of the protective film 30 when the protective film 30 is formed under the conditions mentioned above. FIGs. 6A to 6D are graphs representing results of component analyses of the protective film 30. The component analysis is performed by XPS Analysis (X-ray Photoelectron Spectroscopy). In FIGs. 6A to 6D, the horizontal axes represent the binding energy (eV), and the vertical axes represent the photoelectron intensity.

In FIGs. 6A to 6D, the results of XPS analyses are represented by C1s spectrum, Si2p spectrum, O1s spectrum, and F1s spectrum, respectively. Additionally, in FIGs. 6A to 6D, O₂/CF=1.5 is represented by solid lines, O₂/CF=0.5 is represented by broken lines, and O₂/CF=0 is represented by dashed lines. FIG. 6D illustrates that the amount of -C-F-, included in the protective film 30, is larger under the condition of O₂/CF=0 or 0.5, and that the amount is smaller under the condition of O₂/CF=1.5. On the contrary, FIGs. 6B and 6C illustrate that the amount of -Si-O-, included in the protective film 30, is smaller under the condition of O₂/CF=0 or 0.5, and that the amount is larger under the condition of O₂/CF=1.5. Therefore, the larger O₂/CF, the larger the amount of the SiO₂ included in the protective film 30.

Next, a description will be given of the taper angle of the recess portion of the substrate 10 when the etching process is performed under the following conditions. working pressure: 0.067 Pa
total flow rate of etching gas: 230 sccm
flow rate ofAr gas: 190 to 210 sccm
flow rate of O₂ gas: 0 to 20 sccm
flow rate of C₄F₈: 5 sccm
flow rate of CHF₃: 15 sccm
second high-frequency power source: 2300 w
first high-frequency power source: 600 w
variable capacitor on side of top board: 300 pF

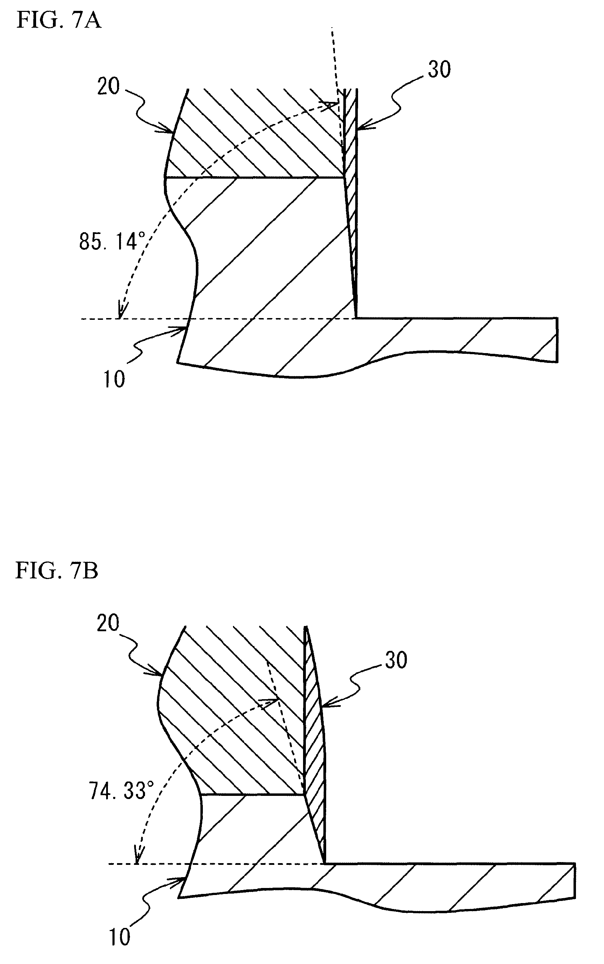

FIGs. 7A and 7B are enlarged views of the vicinity of the recess portion of the substrate 10 after the etching is accomplished. In FIG. 7A, the etching is accomplished under the condition where the O₂/CF is 0.5. As illustrated in FIG. 7A, in the taper angle θ of the recess portion of the substrate 10, 85.14 degrees has been obtained. In FIG. 7B, the etching is accomplished under the conditions where the O₂/CF is 1.0. As illustrated in FIG. 7B, the taper angle θ of 74.33 degrees gas been obtained.

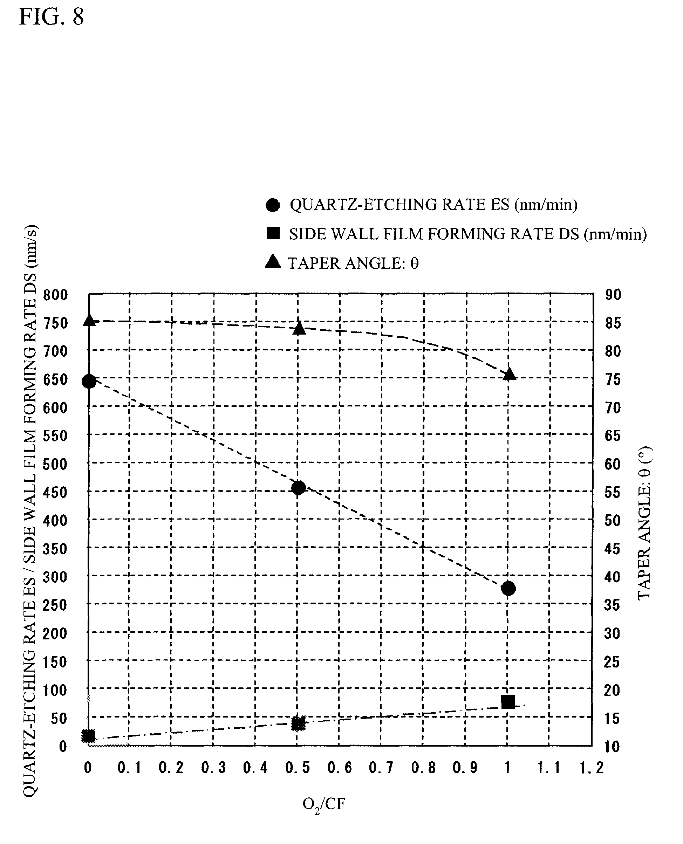

FIG. 8 is a graph indicating relationships among the quartz-etching rate ES (nm/s), the side wall film forming rate DS (nm/s), and the taper angle θ, under the conditions mentioned above. The results of the above experiment are plotted in a graph. In the range of 0.0 to 1.0 in the O₂/CF, the larger the O₂/CF becomes, the smaller the quartz-etching rate ES becomes and the larger the side wall film forming rate DS becomes gently. As the quartz-etching rate ES becomes smaller, or the side wall film forming rate DS becomes smaller, the taper angle θ becomes gentler. Therefore, the side wall film forming rate DS of the protective film 30 and the quartz-etching rate ES can be controlled by controlling O₂/CF. The taper angle θ is determined by the relationship between the side wall film forming rate DS and the etching rate ES, whereby the taper angle θ is controlled by controlling the O₂/CF.

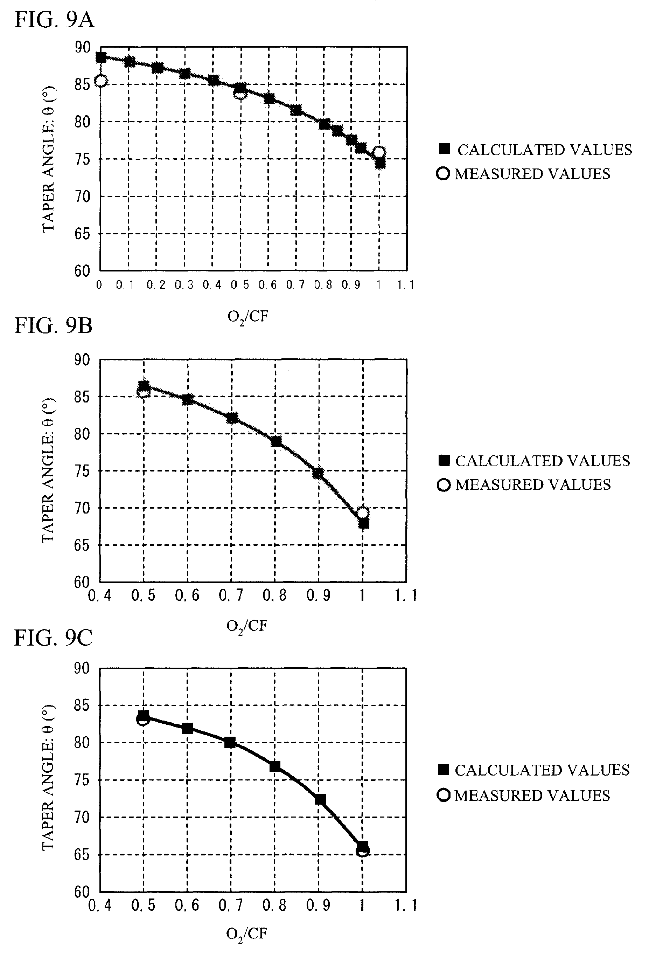

Next, a description will be given of the relationship between the electric power of the first high-frequency power source 125 and the taper angel θ. FIGs. 9A to 9C are graphs representing the relationship between the taper angle θ and O₂/CF under the conditions mentioned above. Calculated values and measured values are represented in FIGs. 9A to 9C. FIG. 9A is a graph representing the relationship between the taper angle θ and O₂/CF when the electric power of the first high-frequency power source 125 is set to 600 w under the conditions mentioned above. Additionally, the calculated values are calculated on the basis of the relationship between the quartz-etching rate ES (nm/s) and the side wall film forming rate DS (nm/s). That is, the values are calculated by using the taper angle θ = arctan(ES/DS). The measured values are plotted in cases where O₂/CF is 0, 0.5, and 1.0.

As illustrated in FIG. 9A, the measured value of the taper angle θ was 84.24 degrees when O₂/CF is 0.5. The measured value of the taper angle θ is 76.03 degrees when O₂/CF is 1.0.

FIG. 9B is a graph representing the relationship between the taper angle θ and O₂/CF when the electric power of the first high-frequency power source 125 is set to 450 w under the conditions mentioned above. When the electric power of the first high-frequency power source 125 is set to 450 w, the measured value of the taper angle θ is 85.62 degrees where O₂/CF is 0.5. The measured value of the taper angle θ is 69.28 degrees where O₂/CF is 1.0.

FIG. 9C is a graph representing the relationship between the taper angle θ and O₂/CF when the electric power of the first high-frequency power source 125 is set to 300 w under the conditions mentioned above. When the electric power of the first high-frequency power source 125 is set to 300w, the measured value of the taper angle θ is 83.61 degrees under the condition where O₂/CF is 0.5. The measured value of the taper angle θ is 65.41 degrees under condition where O₂/CF is 1.0.

When the O₂/CF is 1.0, the smaller the electric power of the first high-frequency power source 125 becomes, the gentler the taper angle θ becomes, as illustrated in FIGs. 9A to 9C. Conceivably, the smaller the electric power of the first high-frequency power source 125 becomes, the smaller the etching rate ES becomes. That is, the relationship between the film forming rate of the protective film 30 and the etching rate ES can be controlled by controlling the biasing power applied to the substrate 10.

Next, a description will be given of the film forming rate of the protective film 30 under the following condition. In contrast to the conditions mentioned above, CF₄ gas and CHF₃ gas is used as a component of the fluorocarbon. working pressure: 0.4 Pa
total flow rate of etching gas: 133.3 sccm
flow rate of Ar gas: 98.3 to 110.8 sccm
flow rate of O₂ gas: 2.5 to 15 sccm
flow rate of CF₄: 10 sccm
flow rate of CHF₃: 10 sccm
second high-frequency power source: 1000 w
first high-frequency power source: 100 w
variable capacitor on side of top board: 300 pF

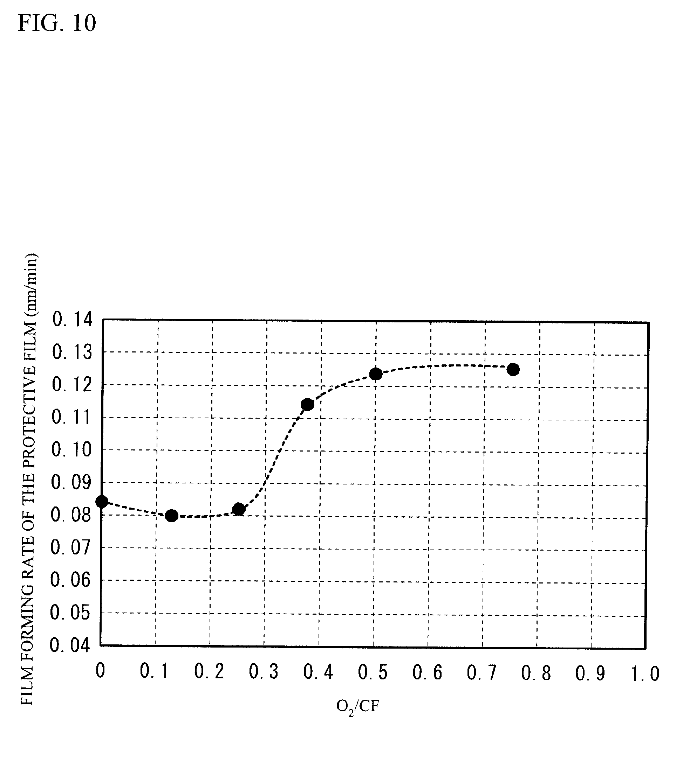

FIG. 10 is a graph representing the relationship between the ratio of O₂ gas and the CF gas, and the film forming rate (µm/min) of the protective film 30. As illustrated in FIG. 10, the film forming rate of the protective film 30 increases as O₂/CF increases from about 0.125. In particular, in the range of about 0.2 to about 0.5 of O₂/CF, the film forming rate of the protective film 30 is rapidly increased. In the range of equal to or more than 0.5 of O₂/CF, the film forming rate of the protective film 30 is gently increased.

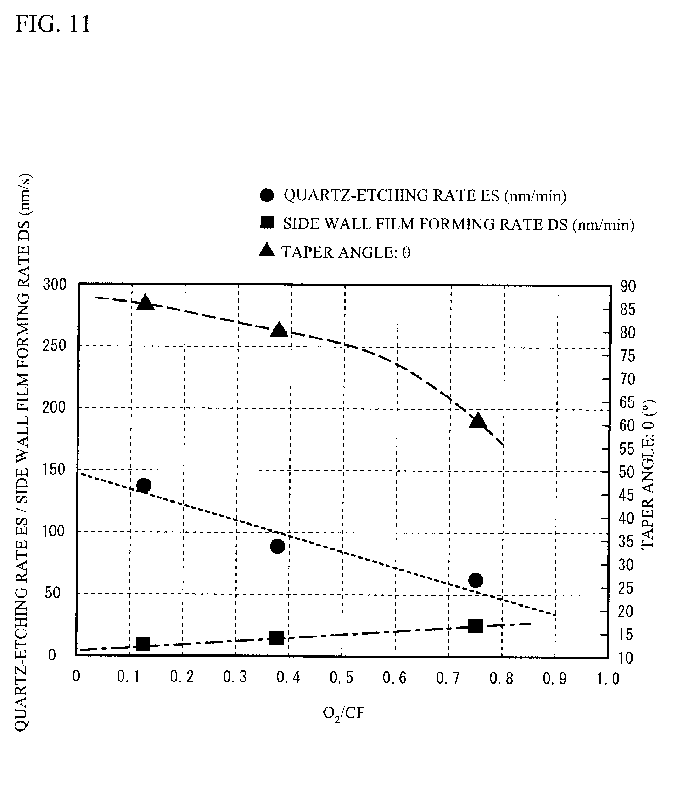

FIG. 11 is a graph representing the relationships among the quartz-etching rate ES (nm/s), the side wall film forming rate DS (nm/s), and O₂/CF, under the conditions mentioned above. As compared with FIG. 8, the etching rate ES and the side wall film forming rate DS are smaller. Also, the taper θ is smaller. This is because the etching rate ES relative to the side wall film forming rate DS becomes smaller, as compared with FIG. 8.

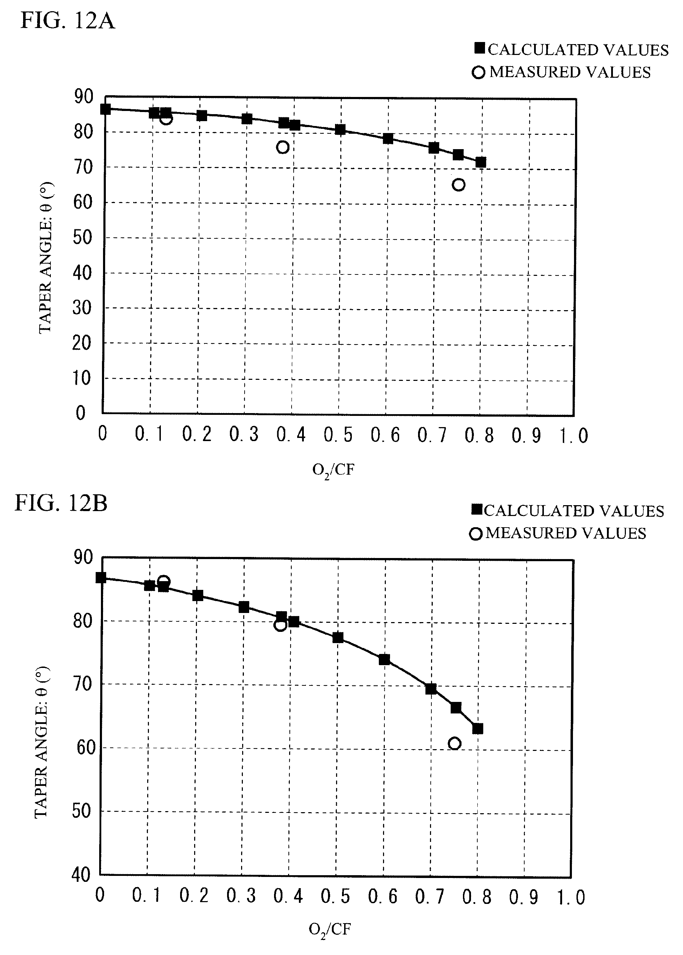

FIGs. 12A and 12B are explanatory views of the relationship between the electric power of the first high-frequency power source 125 and the taper angel θ. Calculated value and measured values are represented in FIGs. 12A and 12B. FIG. 12A is a graph representing the relationship between the taper angle θ and O₂/CF when the electric power of the first high-frequency power source 125 is set to 200 w under the conditions mentioned above. The measured values are plotted under conditions where O₂/CF is 0.125 and 0.375.

As illustrated in FIG. 12A, the measured value of the taper angle θ is 85.24 degrees under the condition where O₂/CF is 0.125. The measured value of the taper angle θ is 75.88 degrees under the condition where O₂/CF is 0.375.

FIG. 12B is a graph representing the relationship between the taper angle θ and O₂/CF when the electric power of the first high-frequency power source 125 is set to 100w. When the electric power of the first high-frequency power source 125 is set to 100w, the measured value of the taper angle θ is 86.46 degrees under the conditions where O₂/CF is 0.125. The measured value of the taper angle θ is 80.35 degrees under the condition where O₂/CF is 0.375.

Next, a description will be given of a method for forming the recess portion with a desirable taper angle in the substrate 10. It is supposed to form the recess portion with 80 degrees in taper angle and with 10 µm in the depth. Further, the taper angle is given by the relationships between the quartz-etching rate ES and the film forming rate. Furthermore, the depth is given by the quartz-etching rate ES.

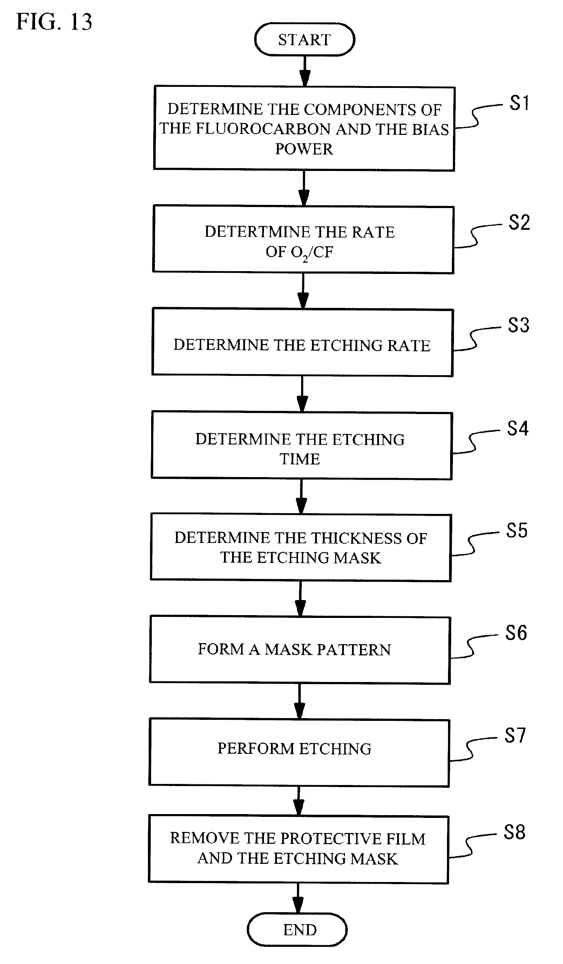

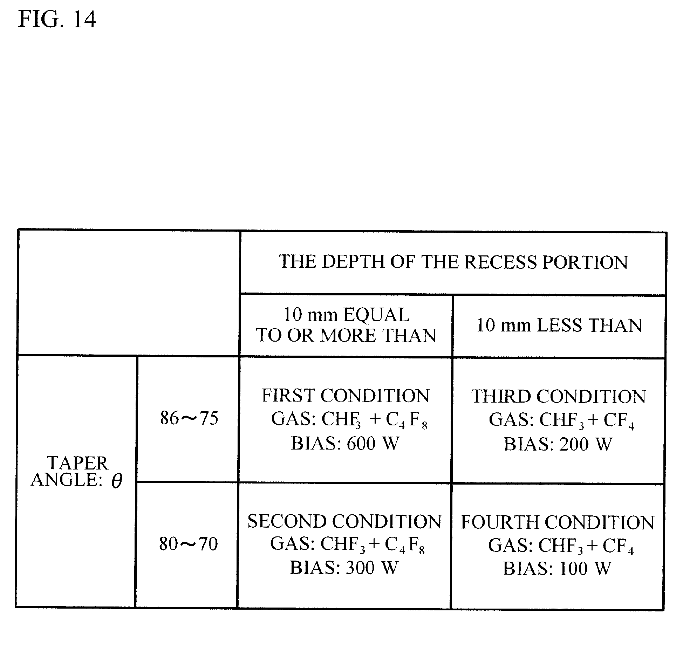

FIG. 13 is a flowchart of the method for producing the mold. First, on the basis of a given map, the electric power of the first high-frequency power source 125 and the components of the fluorocarbon are determined to correspond to desirable taper angle and depth (step S1). In the given map, the electric power of the first high-frequency power source 125 and the components of the fluorocarbon correspond to the taper angle and depth of the recess portion. FIG. 14 is the map in which the electric power of the first high-frequency power source 125 and the components of the fluorocarbon correspond to taper angle and depth of the recess portion. Further, such a map is needed to be calculated beforehand by experiment or the like. Step 1 corresponds to a bias power determination step and a fluorocarbon component determination step.

As illustrated in FIG. 14, the conditions to be set are different between the case where the taper angle θ of the recess portion is from 75 to 86 degrees and the case where that is from 70 to 80 degrees. Further, the conditions to be set are different between the case where the depth of the recess portion is equal to or more than 10 µm and the case where that is less than 10 µm. In the case where the taper angle θ ranges from 75 to 86 degrees and the depth is equal to or more than 10 µm (first condition), CHF₃ + C₄F₈ is used as fluorocarbon, and the electric power of the first high-frequency power source 125 is set to 600 w. In the case where the taper angle θ is from 70 to 80 degrees and the depth is equal to or more than 10 µm (second condition), CHF₃ + C₄F₈ is used as fluorocarbon, and the electric power of the first high-frequency power source 125 is set to 300 w. In the case where the taper angle θ is from 75 to 86 degrees and the depth is less than 10 µm (third condition), CHF₃ + CF₄ is used as fluorocarbon, and the electric power of the first high-frequency power source 125 is set to 200 w. In the case where the taper angle θ is from 70 to 80 degrees and the depth is less than 10 µm (forth condition), CHF₃ + CF₄ is used as fluorocarbon, and the electric power of the first high-frequency power source 125 is set to 100 w.

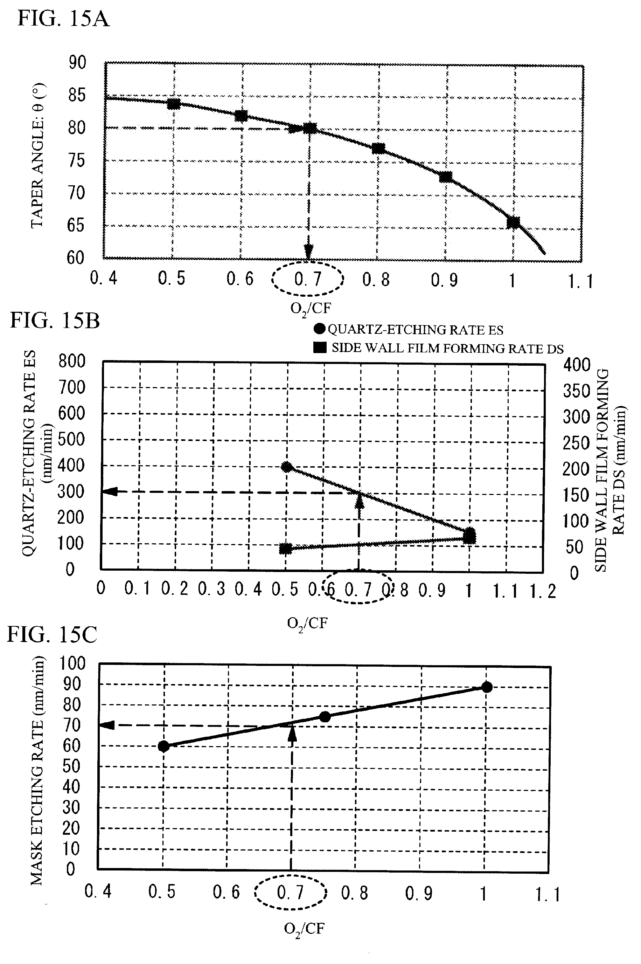

In the case where the taper angle is 80 degrees and the depth is 10 µm, the second condition is employed. Next, referring to a map in which the taper angle corresponds to the rate of O₂/CF, the rate of O₂/CF is determined (step S2). FIGs. 15A to 15C are explanatory views in the case where the recess portion with a desirable taper angle is formed in the substrate 10. FIG. 15A is a map representing the relationship between the taper angle and O₂/CF. In the cases where the taper angle θ is 80 degrees, O₂/CF is determined to 0.7 on the basis of the map as illustrated in FIG. 15A. Further, step S2 corresponds to a gas ratio determination step.

Next, referring to a map in which O₂/CF is related to the etching rate of the substrate 10, the etching rate, of the substrate 10, associated with O₂/CF determined in step S2 is determined (step S3). FIG. 15B is a map representing the relationship between the etching rate and O₂/CF. In the case where O₂/CF is 0.7, the quartz-etching rate ES can be calculated on the basis of the map illustrated in FIG. 15B. Step S3 corresponds to the etching rate determination step.

Next, the etching time is determined on the basis of the determined etching rate ES and the desirable etching depth (step S4). In order to form the recess portion with the depth of 10 µm in the substrate 10, the etching time is 1000/300 minutes, namely, 33.33 minutes, which is substantially equal to 33 minutes, 22 seconds by calculation. Step S4 corresponds to the etching time determination step.

Next, on the basis of the determined etching rate ES and the determined etching tame, the thickness of the etching mask 20 is determined (step S5). FIG. 15C is a map representing the relationship between O₂/CF and the etching rate of the etching mask 20. In the case where O₂/CF is 0.7, the etching rate is 70 nm/minute on the basis of the map illustrated in FIG. 15C. Since the etching time is 33 minutes, 20 seconds, the thickness of the etching mask 20 that is endurable for such an etching time is calculated by 70×33.33=2333 nm. Therefore, it is recognized that the thickness of the etching mask 20 is needed to be equal to or more than 2.333 µm. Step S5 corresponds to the mask thickness determination step.

Next, a mask pattern is formed on the front surface of the substrate 10 (step S6), and etching is performed (step S7). The protective film 30 and remained etching mask 20 are then removed (step S8).

Further, the maps as illustrated in FIGs. 15A to 15C are calculated beforehand by an experiment conducted under given conditions. Furthermore, the maps as illustrated in FIGs. 15A to 15C are needed to be calculated beforehand for every condition mentioned above

In this manner, O₂/CF associated with the desirable taper angle is calculated, and the quartz-etching rate and the mask-etching rate are calculated on the basis of the calculated O₂/CF. Therefore, the needed etching time and the needed thickness of the etching mask 20 can be calculated, thereby forming the recess portion with the desirable taper angle in the substrate 10. Consequently, the mold having a dimension with high accuracy can be produced.

All examples and conditional language recited herein are intended for pedagogical purposes to aid the reader in understanding the invention and the concepts contributed by the inventor to furthering the art, and are to be constructed as being without limitation to such specifically recited examples and conditions, nor does the organization of such examples in the specification relate to a showing of the superiority and inferiority of the invention. Although the embodiment of the present inventions has been described in detail, it should be understood that the various changes, substitutions, and alterations could be made hereto without departing from the sprit and scope of the invention.

## Claims

1. A method for producing a mold, used for imprint, by dry etching a substrate made of quartz by using a dry etching apparatus, the method comprising:
a mask forming step for forming an etching mask having a concave and convex pattern on the substrate, and
an etching step for forming a protective film on a side wall of the etching mask and for etching the substrate at the same time.

2. The method of claim 1, wherein the etching step controls a relationship between a film forming rate of the protective film and an etching rate of the substrate.

3. The method of claim 1, wherein the etching step controls the relationship between the film forming rate of the protective film and an etching rate of the substrate by controlling a O₂/CF ratio of oxygen and fluorocarbon included in an etching gas introduced into a vacuum chamber of the dry etching apparatus.

4. The method of claim 3, wherein the etching step reduces a ratio of the etching rate of the substrate relative to the film forming rate of the protective film by causing the O₂/CF ratio to become larger, and increases the ratio of the etching rate of the substrate relative to the film forming rate of the protective film by causing the O₂/CF ratio to become smaller.

5. The method of claim 1, wherein the etching step controls the relationship between the film forming rate of the protective film and the etching rate of the substrate by controlling a biasing electric power applied to the substrate.

6. The method of claim 1, further comprising a bias power determination step for determining a biasing electric power applied to the substrate with reference to a map in which the biasing electric power applied to the substrate corresponds to a relationship between the film forming rate of the protective film and the etching rate of the substrate.

7. The method of claim 1, further comprising a fluorocarbon components determination step for determining a component of the fluorocarbon with reference to a map in which the component of the fluorocarbon corresponds to a relationship between the film forming rate of the protective film and the etching rate of the substrate.

8. The method of claim 1, further comprising a gas ratio determination step for determining the O₂/CF ratio with reference to a map in which the O₂/CF ratio corresponds to a relationship between the film forming rate of the protective film and the etching rate of the substrate.

9. The method of claim 8, further comprising an etching rate determination step for determining the etching rate of the substrate relative to O₂/CF ratio determined with reference to a map in which the O₂/CF ratio corresponds to the etching rate of the substrate.

10. The method of claim 9, further comprising a mask thickness determination step for determining a thickness of the etching mask needed on the basis of the etching rate determined and the etching time determined.

11. The method of claim 1, wherein the protective film includes SiO₂.
